Europäisches Patentamt

**European Patent Office**

**Office européen des brevets**

(19)

(11) Numéro de publication: **0 242 292
B1**

# FASCICULE DE BREVET EUROPEEN

(12)

(45) Date de publication du fascicule du brevet:
21.03.90

(21) Numéro de dépôt: 87400846.9

(22) Date de dépôt: 14.04.87

(51) Int. Cl.⁴: **H03C 3/22, H03B 5/12**

(54) **Oscillateur commandé par une tension, doubleur de fréquence.**

(30) Priorité: **18.04.86 FR 8605651**

(43) Date de publication de la demande:
**21.10.87 Bulletin 87/43**

(45) Mention de la délivrance du brevet:
**21.03.90 Bulletin 90/12**

(84) Etats contractants désignés:
**DE GB NL SE**

(56) Documents cités:
**EP-A- 0 017 899
EP-A- 0 085 241
DE-B- 1 303 540**

**NEW ELECTRONICS,
vol. 15, no. 24, 14 décembre 1982, page 19, Harpenden,
Herts, GB; I. MARCH: "A wide range v.c.o."
1980 IEEE INTERNATIONAL SOLID-STATE CIRCUITS
CONFERENCE, février 1980, pages 118,119, IEEE, New
York, US; R. VAN TUYL: "A monolithic GaAs FET RF
signal generation chip"**

(73) Titulaire: **THOMSON-CSF, 51, Esplanade du Général de
Gaulle, F-92800 Puteaux(FR)**

(72) Inventeur: **Mamodaly, Narguise, THOMSON-CSF
SCPI 19, avenue de Messine, F-75008 Paris(FR)**
Inventeur: **Kaminsky, Didier, THOMSON-CSF
SCPI 19, avenue de Messine, F-75008 Paris(FR)**

(74) Mandataire: **Taboureau, James et al, THOMSON-CSF
SCPI, F-92045 Paris La Défense Cédex 67(FR)**

## Description

La présente invention concerne un circuit électronique hyperfréquence, et plus précisément un oscillateur contrôlé par une tension, doubleur de fréquence et à faible bruit de modulation de fréquence aux environs de sa fréquence centrale d'oscillation, dite porteuse.

Par définition, un oscillateur contrôlé par une tension, plus connu sous le sigle VCO (de l'anglais Voltage Controlled Oscillator) nécessite d'avoir un circuit résonant qui lui permette d'osciller dans une vaste plage de fréquences, correspondant à une courbe aplatie de fréquence en fonction de la tension, tandis qu'un oscillateur pour une fréquence pure a une courbe très resserrée, avec le moins possible de bruit en modulation de fréquence, dit bruit FM, autour de la porteuse.

Or l'une des caractéristiques pour lesquelles les VCO sont encore limités est d'avoir trop de bruit FM autour de la porteuse. A titre d'exemple, pour des oscillateurs à transistors à effet de champ à très large bande (1 octave), un bruit FM de -65 à - 80 dBc/Hz à 100 kHz autour de la porteuse à 5 GHz est une valeur courante.

Pour améliorer ce bruit FM autour de la porteuse, il est connu de réaliser un VCO sous forme d'oscillateur doubleur, dans lequel deux transistors sont montés en parallèle et travaillent dans des conditions telles que leurs courants de drains soient en opposition de phases pour le mode fondamental voir par exemple, l'article paru dans New Electronics, vol. 15, no. 24, le 14.12.82, page 19, de I. March intitulé: "A wide range v.c.o"

Selon l'invention, le moyen qui permet aux deux transistors d'être, sur leurs sorties, en opposition de phase, consiste en un varactor, ou diode à capacité variable, dont chaque borne d'accès est reliée à une grille d'un transistor à effet de champ, ou à la base si le VCO doubleur est réalisé en transistors bipolaires. Le varactor est donc monté en pont entre les deux grilles des deux transistors. On entend par varactor un dispositif de type diode à jonction dont la réactance peut être modifiée de façon contrôlée par une tension de polarisation.

De façon plus précise, l'invention concerne un oscillateur contrôlé par une tension, doubleur de fréquence, comportant deux transistors travaillant en parallèle, dont les courants recueillis sur l'une de leurs électrodes d'accès (source ou drain) sont en opposition de phase, de façon à diminuer le bruit en modulation de fréquence autour de la fréquence fondamentale de l'oscillateur, cet oscillateur étant caractérisé en ce qu'il comporte un unique circuit pour les deux grilles des deux transistors, constitué par un varactor dont chaque borne d'accès est réunie à une grille de transistor.

L'invention sera mieux comprise, et ses avantages ressortiront de la description de deux exemples d'application, s'appuyant sur les figures jointes en annexe, qui représentent :

- figure 1 : schéma simplifié d'un oscillateur doubleur, selon l'art connu,
- figure 2 : schéma électrique d'un oscillateur doubleur selon l'invention,
- figure 3 : schéma électrique d'une variante de montage de l'oscillateur doubleur selon l'invention.

Les oscillateurs doubleurs sont des dispositifs connus qui associent deux transistors, généralement deux transistors à effet de champ en hyperfréquence, qui travaillent en parallèle, et dont les circuits résonants sont tels que, si leur grille oscille à une fréquence $f_o$, le courant sur leur électrode de sortie, source ou drain, oscille à une fréquence $2f_o$.

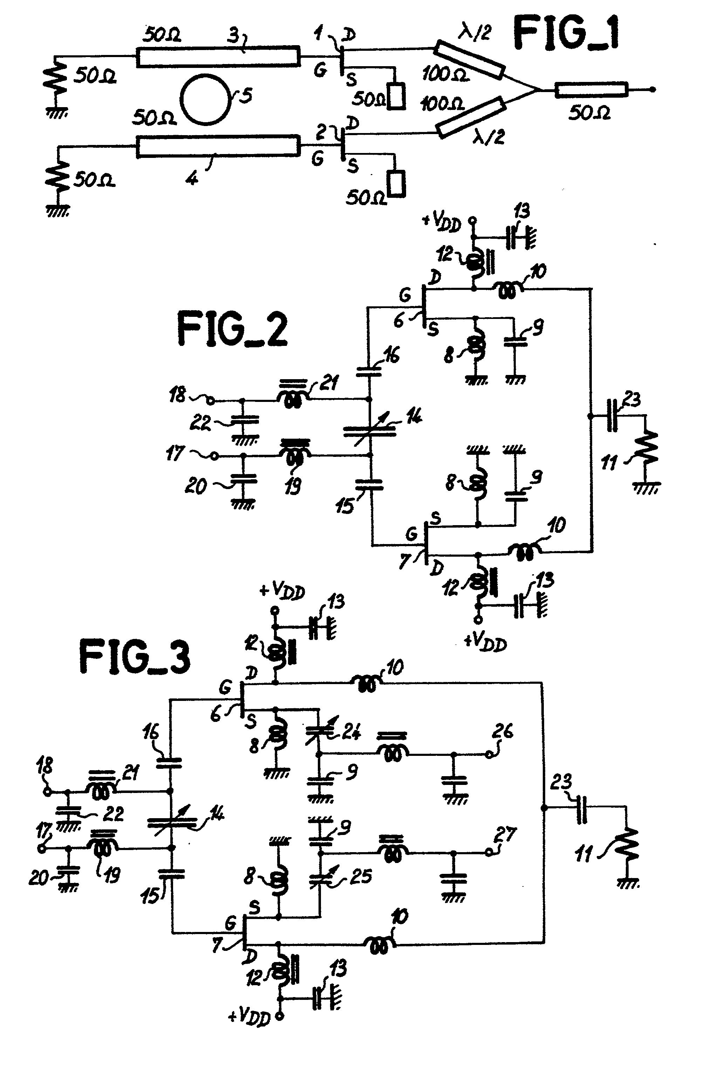

Un exemple d'oscillateur doubleur, connu, est donné en figure 1. Il est d'un type désigné par le vocable "push-push". Deux transistors à effet de champ 1 et 2 travaillent en parallèle, et on les oblige à osciller en opposition de phase. Pour cela, deux microbandes 3 et 4, parallèles entre elles, sont connectées, chacune, sur la grille d'un transistor. Une réactance est connectée à chacune des sources, et l'énergie totale est recueillie sur un transformateur d'impédance connecté aux drains : ce montage, ainsi que la polarisation des transistors, fait partie des connaissances de l'homme de l'art.

Entre les deux microbandes 3 et 4 est positionné un résonateur diélectrique 5. Puisque les circuits de grille de chaque transistor sont sur les côtés opposés du résonateur diélectrique 5, les courants de chaque grille sont couplés et exactement en opposition de phase. Dans ces conditions, chaque transistor est asservi en phase à l'autre transistor, et la seconde harmonique de leur énergie est en phase à la sortie de l'oscillateur, sur les drains.

En fait, le résonateur diélectrique présente des difficultés de mise en oeuvre. D'abord, on sait que les résonateurs diélectriques sont de petits cylindres de céramiques et, à des fréquences de l'ordre de 20 GHz, ils ont un diamètre de l'ordre de 1 mm : c'est petit pour l'usinage, et très gros pour être déposé et positionné sur la pastille d'un circuit intégré. Ensuite, les résonateurs sont résistifs à plusieurs fréquences,puisque plusieurs modes sont possibles, outre le mode fondamental, dans une structure cylindrique donnée. Donc des modes hybrides et d'ordres supérieurs peuvent être excités par une même structure de couplage. Le circuit d'oscillateur doit donc être conçu pour prévenir l'oscillation à des fréquences non désirées.

L'oscillateur contrôlé en tension, selon l'invention, évite les inconvénients du résonateur diélectrique, et est intégrable sur une pastille de matériau semiconducteur, silicium ou matériau du groupe III-V tel que GaAs, selon la fréquence. Il est également de type "push-push".

Il comprend deux voies identiques. Sur la figure 2, deux transistors à effet de champ 6 et 7 ont, chacun, leur source connectée à un circuit LC composé d'une self 8 et d'une capacité 9, tandis que leurs deux drains sont réunis ensemble, à travers une self 10 et une capacité 23, à une charge 11. La capacité 23 découple le continu des hyperfréquences. Les deux transistors sont alimentés par leurs drains à partir d'une tension $+V_{DD}$, à travers une self 12, avec une capacité de découplage 13.

L'originalité du circuit vient de ce que l'opposition de phase, à la fréquence fondamentale, entre les deux grilles des deux transistors est obtenue au moyen d'un varactor, dont chaque borne d'accès est réunie à la grille d'un transistor.

Un varactor est une jonction PN ou Schottky polarisée en inverse : ce dispositif se présente alors, en fonction de la tension appliquée à ses bornes, comme une capacité variable en série avec une faible résistance. Un varactor est donc une diode polarisée en inverse : les meilleurs varactors actuels sont les varactors hyperabrupts en GaAs.

Un varactor 14 est donc connecté entre les grilles des deux transistors 6 et 7 : chacune de ses bornes d'accès est cependant réunie à une grille à travers une capacité, 15 ou 16, de façon à ce que la grille considérée soit découplée en courant continu. En effet, le varactor 14 nécessite une tension de polarisation, qui est appliquée directement à ses bornes, entre les connexions 17 et 18 d'accès extérieur, cette tension étant filtrée par les selfs 19 et 21 et les capacités de découplage 20 et 22.

Dans un oscillateur accordable par varactor, c'est la variation de susceptance présentée par les circuits associés au transistors à qui limite en premier lieu la bande d'accord électronique. Dans l'oscillateur selon l'invention, il n'y a pas de self-inductance en parallèle sur les bornes des transistors, et dans ce cas la plage de fréquences du VCO est donnée par :

$$\omega_{max}/\omega_{min} = \sqrt{C_{max}/C_{min}}$$

sachant que la fréquence f est liée à la pulsation par $\omega = 2\pi f$, $C_{max}$ et $C_{min}$ étant les valeurs extrêmes du varactor 14. Pratiquement, il existe toujours une faible self inductance dûe aux connexions. Cette dernière a pour effet de diminuer la largeur de bande à conductance négative : le varactor 14 augmente la plage de résistance négative, et modifie l'impédance des circuits de grilles.

L'un des problèmes posés par les varactors est qu'ils nécessitent d'amener directement à leurs bornes la tension de polarisation : celle-ci entraine des réactances parasites supplémentaires. Pour obtenir une bande d'accord plus élevée, on peut placer un autre varactor d'accord dans le circuit de source, pour chaque transistor du VCO.

C'est cette variante qui est représentée en figure 3. Le circuit des grilles des transistors 6 et 7 est identique à celui de la figure précédente, et comprend un premier varactor 14. Mais deux autres varactors 24 et 25 sont montés dans le circuit de source des transistors 6 et 7, le varactor 24 dans le circuit du transistor 6 et le varactor 25 dans le circuit du transistor 7. Chacun de ces varactors est introduit entre la self 8 et la capacité 9 de découplage du crcuit de source.

Selon la technique connue de l'homme de l'art, les second et troisième varactors 24 et 25 sont polarisés en inverse, par une tension entre les bornes 26 et la masse pour le varactor 24, et par une tension entre les bornes 27 et la masse pour le varactor 25.

Les tensions d'alimentation des varactors 24 et 25 sont elles-mêmes filtrées.

Les varactors montés dans les circuits de sources modifient l'impédance de source et augmentent la plage de résistance négative : la bande d'accord du VCO est plus large, puisqu'elle est fonction des capacités des varactors et des capacités de source.

En outre, puisque les deux transistors travaillent en opposition de phase, le bruit FM autour de la porteuse est amélioré : on a mesuré pour un VCO ne comportant qu'un seul varactor 14 de grilles un bruit FM de -75dBc/Hz à 10kHz de la porteuse, et une valeur évaluée à -105dBc/Hz à 100kHz de la porteuse à 5,5GHz (mode fondamental à 2,75GHz). Le bruit FM à 100kHz n'a pu être qu'évalué car il est si faible que le bruit FM de l'analyseur de spectre intervient.

L'oscillateur commandé par une tension a été décrit en s'appuyant sur des transistors à effet de champ, mais sa structure se prête à une adaptation aux transistors bipolaires, selon la fréquence.

Cette structure permet l'intégration monolithique, car les varactors sont des diodes, intégrables au même titre que les transistors, les selfs et capacités, surtout en hyperfréquences.

L'oscillateur commandé par une tension, selon l'invention, est utilisé dans les chaines de traitement de l'information, ou comme oscillateur local, pour les radars et télécommunications.

Il est précisé par les revendications suivantes.

**Revendications**

1. Oscillateur contrôlé par une tension, doubleur de fréquence, comportant deux transistors (6,7) travaillant en parallèle, dont les courants recueillis sur l'une de leurs électrodes d'accès, source ou drain, sont en opposition de phase, de façon à diminuer le bruit en modulation de fréquence autour de la fréquence fondamentale de l'oscillateur, cet oscillateur étant caractérisé en ce qu'il comporte un unique circuit pour les deux grilles des deux transistors (6,7), constitué par un varactor (14) dont chaque borne d'accès est réunie à une grille de transistor (6,7).

2. Oscillateur selon la revendication 1, caractérisé en ce que, entre chaque borne d'accès du varactor (14) et chaque grille des deux transistors (6,7), est montée une capacité (15,16), de façon à découpler les grilles en courant continu.

3. Oscillateur selon la revendication 2, caractérisé en ce que le varactor (14) est polarisé en inverse, en courant continu, par une tension extérieure appliquée entre deux bornes (17,18), ladite tension de polarisation étant découplée de chacune des grilles des transistors (6,7) par une capacité (15,16).

4. Oscillateur selon la revendication 1, caractérisé en ce que l'énergie est recueillie sur le drain de chaque transistor (6,7), à travers une self-inductance (10), les courants de drain des deux transistors étant couplés et appliqués à une charge (11).

5. Oscillateur selon la revendication 1, caractérisé en ce qu'il comporte en outre un deuxième et un troisième varactors (24, 25) montés dans les circuits de sources des deux transistors (6,7), chacun de ces varactors (24, 25) étant monté entre la self (8) et la capacité de découplage (9) du circuit de grille d'un transistor.

6. Oscillateur selon la revendication 5, caractérisé en ce que les deuxième et troisième varactors (24, 25) sont polarisés en inverses, en courant continue, par une tension extérieure appliquée entre une borne (26, 27), commune au varactor (24, 25) et la capacité de découplage (9), et la masse.

**Patentansprüche**

1. Spannungsgesteuerter Oszillator, Frequenzverdoppler, mit zwei parallel arbeitenden Transistoren (6, 7), deren Ströme, die auf einer ihrer Zugangselektroden, Quelle oder Drain, aufgenommen werden, gegenphasig sind, so daß das Frequenzmodulations-Rauschen um die Grundfrequenz des Oszillators herum gedämpft wird, wobei dieser Oszillator dadurch gekennzeichnet ist, daß er einen einzigen Kreis für die beiden Gateelektroden der beiden Transistoren (6, 7) umfaßt, der aus einem Varaktor (14) gebildet ist, von dem jeder Zugangsanschluß mit einem Transistorgate (6, 7) vereint ist.

2. Oszillator nach Anspruch 1, dadurch gekennzeichnet, daß zwischen jedem Zugangsanschluß des Varaktors (14) und jedem Gate der beiden Transistoren (6, 7) eine Kapazität (15, 16) geschaltet ist, so daß die Gates gleichstrommäßig entkoppelt werden.

3. Oszillator nach Anspruch 2, dadurch gekennzeichnet, daß der Varaktor (14) gleichstrommäßig durch eine zwischen zwei Anschlüssen (17, 18) angelegte externe Spannung in Sperrrichtung gepolt ist, wobei diese Polarisationsspannung von jedem der Gates der Transistoren (6, 7) durch eine Kapazität (15, 16) entkoppelt wird.

4. Oszillator nach Anspruch 1, dadurch gekennzeichnet, daß die Energie auf dem Drain eines jeden Transistors (6, 7) über eine Selbstinduktivität (10) aufgenommen wird, wobei die Drainströme der beiden Transistoren gekoppelt und auf eine Last (11) angelegt sind.

5. Oszillator nach Anspruch 1, dadurch gekennzeichnet, daß er außerdem einen zweiten und einen dritten Varaktor (24, 25) umfaßt, die in die Source-Kreise der beiden Transistoren (6, 7) geschaltet sind, wobei jeder dieser Varaktoren (24, 25) zwischen der Drosselspule (8) und der Entkopplungskapazität (9) des Gate-Kreises eines Transistors geschaltet ist.

6. Oszillator nach Anspruch 5, dadurch gekennzeichnet, daß der zweite und der dritte Varaktor (24, 25) gleichstrommäßig durch eine externe Spannung in Sperrrichtung gepolt sind, die zwischen einem dem Varaktor (24, 25) und der Entkopplungskapazität (9) gemeinsamen Anschluß (26, 27) und der Masse angelegt ist.

**Claims**

1. A frequency doubling, voltage controlled oscillator comprising two transistors (6 and 7), operating in parallel, of which the currents taken at one of their access electrodes, source or drain, are opposite in phase in such a manner as to diminish the noise inherent in frequency modulation around the fundamental frequency of the oscillator, said oscillator being characterized in that it comprises a single circuit for the two gates of the two transistors (6 and 7), constituted by a varactor (14), of which each access terminal is connected with one gate of the transistors (6 and 7).

2. The oscillator as claimed in claim 1, characterized in that between each access terminal of the varactor (14) and each gate of the two transistors (6 and 7) a capacitor (15 and 16) is arranged in such a manner as to cause DC decoupling of the gates.

3. The oscillator as claimed in claim 2, characterized in that the varactor (14) is inversely biased for DC by an exterior voltage applied between two terminals (17 and 18), the said biasing voltage being decoupled from each of the gates of the transistors (6 and 7) by a capacitor (15 and 16).

4. The oscillator as claimed in claim 1, characterized in that the power is abstracted at the drain of each transistor (6 and 7) through a self-inductance (10), the drain currents of the two transistors being coupled and applied to a load (11).

5. The oscillator as claimed in claim 1, characterized in that it furthermore comprises a second and a third varactor (24 and 25) placed in the source circuits of the two transistors (6 and 7), each of these varactors (24 and 25) being placed between the self-inductance (8) and the decoupling capacitor (9) of the gate circuit of a transistor.

6. The oscillator as claimed in claim 5, characterized in that the second and the third varactors (24 and 25) are inversely biased DC-wise by an exterior voltage applied between a terminal (26 and 27), common to the varactor (24 and 25) and the decoupling capacitor (9), and ground.

FIG_1

FIG_2

FIG_3